# EUROPÄISCHE PATENTSCHRIFT

(11) **EP 1 921 643 B1**
(45) Veröffentlichungstag und Bekanntmachung des Hinweises auf die Patenterteilung: **02.05.2012**
(21) Anmeldenummer: 07018492.4
(22) Anmeldetag: 20.09.2007
(51) Int. Cl.: H01H 13/81, H05K 3/40

(54) **Anpress-Kontakt-Array**
Pressure contact array
Matrice de contact par pression

(30) Priorität: 07.11.2006 DE 102006052462
(43) Veröffentlichungstag der Anmeldung: 14.05.2008
(73) Patentinhaber: Amphenol-Tuchel Electronics GmbH, 74080 Heilbronn (DE)
(72) Erfinder: Poguntke, Matthias, 74074 Heilbronn (DE); Kaiser, Olga, 74080 Heilbronn (DE)
(74) Vertreter: Wagner, Karl H.

(56) Entgegenhaltungen:
- WO-A-98/26637
- DE-A1- 4 301 928
- JP-A- 7 335 679
- US-A- 5 791 911

## Beschreibung

Die Erfindung bezieht sich insbesondere auf eine Anpress-Kontakt-Array bzw. eine Anpresskontaktanordnung, die insbesondere SMD-lötbar ist. Die Erfindung bezieht sich ferner auf ein Verfahren zur Anbringung von Anpresskontakten an einer Leiterplatte und zwar insbesondere mittels einer Anpresskontaktanordnung. Die Erfindung bezieht sich allgemein auf eine Anschlusskontaktanordnung.

Leiterplatten besitzen insbesondere zu Anschlusszwecken Kontaktflächen, an denen beispielsweise Bauteile angelötet werden können. Diese Kontaktflächen werden häufig auch als Pad-Flächen oder kurz als Pads bezeichnet. Im Folgenden werden diese Pads, nachdem sie sich auf der Leiterplatte befinden, als Leiterplatten-Pads bezeichnet.

Es ist häufig erforderlich, an den Leiterplatten-Pads, Bauteile, insbesondere Kontaktpads oder Pad-Elemente anzulöten. Wenn diese Pad-Elemente mit Anpresskontaktzonen versehen sind, so können die Pad-Elemente zum Kontaktieren von z.B. Anpresskontakten für den Anschluss von z.B. Lautsprechern oder Tastaturen dienen, wobei die Pad-Elemente als Anpresskontakte oder Anpresskontaktelemente bezeichnet werden. Ein Lautsprecher oder eine Tastatur würde dann beispielsweise Anpresskontakte aufweisen, z.B. Löffelkontakte, die auf die Anpresskontaktzonen der Pad-Elemente drücken. Diese Anpresskontakte bzw. Anpresskontaktelemente können beispielsweise aus Gold bestehen, um a) die Kontaktsicherheit zu erhöhen und b) die oftmals notwendigen niedrigen Übergangswiderstände zu erreichen.

Eine solche Anschlusskontaktanordnung ist aus dem Dokument JP-A-07335679 bekannt.

Es ist außerordentlich schwierig, eine sichere Positionierung solcher Bauteile, insbesondere der Anpresskontakte während des Reflow-Prozesses bezüglich der Leiterplatten-Pads sicherzustellen. Kleinere Bauteile oder Anpresskontakte können nämlich auf der Lötflüssigkeit "schwimmen" und dabei ihre genaue Position verlieren. Das kann so weit gehen, dass die Anpresskontakte ihre eigentliche Funktion nicht mehr erfüllen können. Beispielsweise kann ein Kurzschluss mit anderen Leiterplatten-Pads oder auch mit anderen Anpresskontakten entstehen.

Es ist ein Ziel der Erfindung, eine hohe Positioniergenauigkeit für Bauteile, insbesondere Anpresskontakte, vorzusehen. Ferner soll eine möglichst geringe Bauteildicke möglich sein. Wenn mehr als ein Anpresskontakt angelötet werden muss, so sollen die Anpresskontakte eine gute Koplanarität zeigen.

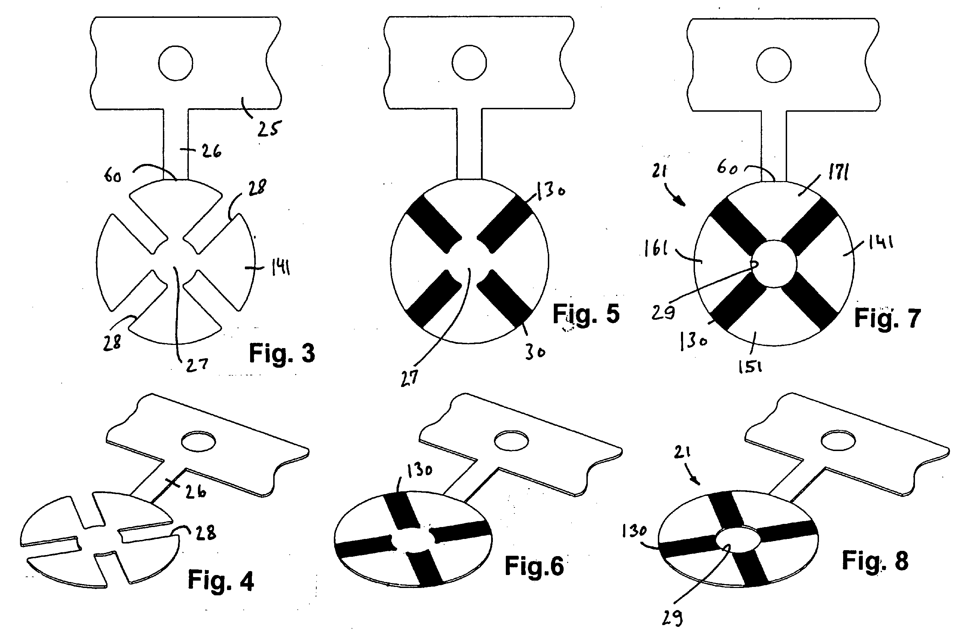

Erfindungsgemäß werden mehrere, insbesondere auch zwei Anpresskontakte in einem einzigen Bauteil zusammengefasst. Ein solcher Bauteil weist dann - vgl. Fig. 3 - also mehrere Anpresskontakte auf. Wenn mehrere Anpresskontakte als eine Einheit, vorzugsweise in einem zusammenhängenden Stanzgitter vorgesehen werden, so wird im Folgenden auf die einzelnen Anpresskontakte eines solches Bauteils als Pad-Elemente Bezug genommen.

Nach dem Stanzen der Grundformen der Pad-Elemente in einem ersten Verfahrensschritt, werden diese sodann in einem zweiten Verfahrensschritt, vorzugsweise noch mit einander verbunden und an dem Pilot- oder Stanzstreifen hängend, mit einem Formstoff umspritzt, der in die die einzelnen Pad-Elemente trennenden Schlitze eintritt. Anschließend folgt in einem dritten Schritt in einem End-Stanzprozesses eine endgültige galvanische Trennung der Pad-Elemente.

Insbesondere während die die Pad-Elemente aufweisenden Anordnung noch am Stanzstreifen befestigt ist, wird die Positionierung gegenüber den Leiterplatten-Pads vorgenommen und sodann der Lötvorgang eingeleitet. Dadurch dass die am Pilotstreifen befestigten Pad-Elemente miteinander bzw. zueinander fixiert sind, verlieren sie nicht ihre genaue Positionierung.

Erfindungsgemäß wird insbesondere eine Anpasskontaktanordnung und auch allgemein eine Anschlusskontaktanordnung gemäß Anspruch 1 sowie ein Verfahren zur Herstellung einer Anschluss- bzw. Anpresskontaktanordnung gemäß Anspruch 9 vorgesehen. Bevorzugte Ausgestaltungen der Erfindung ergeben sich aus den Unteransprüchen.

Weitere Vorteile, Ziele und Einzelheiten der Erfindung ergeben sich aus der Beschreibung von Ausführungsbeispielen anhand der Zeichnung; in der Zeichnung zeigt:
- Fig. 1: eine schematische Draufsicht auf eine Leiterplatte;
- Fig. 2: eine Draufsicht auf vier getrennt angeordnete Anpresskontakte, die auch als Pad-Elemente bezeichnet werden können;
- Fig.3: eine Draufsicht auf ein aus leitendem Flächenmaterial, vorzugsweise Metallblech bestehenden Bauteil, bei dem vier Pad-Elemente durch eingestanzte Schlitze getrennt sind, aber noch durch eine mittig angeordnete Scheibe verbunden bleiben (Verfahrensschritt: Stanzen);
- Fig. 4: eine perspektivische Draufsicht auf die Darstellung gemäß Fig. 3;
- Fig. 5: eine Draufsicht ähnlich Fig. 3, wobei hier in einem weiteren Verfahrensschritt "Stanzen" die Schlitze mit einem Formstoff ausgefüllt sind, der die einzelnen Pad-Elemente verbindet;
- Fig. 6: eine perspektivische Draufsicht auf die Pad-Elemente gemäß Fig. 5;
- Fig. 7: eine Draufsicht ähnlich Fig. 5, wobei hier der die Pad-Elemente verbindende Scheibenteil herausgestanzt ist, so dass ein Loch verbleibt, wobei dank des in den Schlitzen verbleibenden Formstoffs die vier Pad-Elemente weiterhin eine Einheit bilden, obwohl das erwähnte Loch bereits gestanzt ist (Verfahrensschritt: Endstanzen);
- Fig. 8: eine perspektivische Ansicht der Fig. 7;
- Fig. 9: eine Anordnung ähnlich wie in Fig. 3, wobei hier die Pad-Elemente eine quadratische Form besitzen und mit zwei Stegen am Stanzstreifen oder Pilotstreifen befestigt sind;
- Fig. 10: eine perspektivische Darstellung der Fig. 9;
- Fig. 11: eine Draufsicht wie in Fig. 9, wobei hier der Formstoff in die Schlitze eingebracht ist;
- Fig. 12: eine perspektivische Ansicht der Fig. 11;
- Fig. 13: eine Draufsicht, gemäß welcher eine kreuzförmige Scheibe, welche die quadratischen Pad-Elemente verbunden hat, herausgestanzt ist;
- Fig. 14: eine perspektivische Ansicht der Fig. 13;
- Fig. 15: eine Draufsicht auf zwei Pad-Elemente, die nach einem ersten Stanzschritt an einem Pilotstreifen befestigt sind, das eine oder erste Pad-Element eine ringförmige Scheibe aufweist, in deren Mitte ein zweites Pad-Element bildendes kreisförmiges Plättchen angeordnet ist, welches durch Verbindungsstege an der ringförmigen Scheibe befestigt ist;
- Fig. 16: eine perspektivische Draufsicht auf die Anordnung gemäß Fig. 15;
- Fig. 17: eine Draufsicht ähnlich Fig. 15, wobei hier in einem weiteren Verfahrensschritt Formstoff in die Schlitze eingespritzt ist, die die ringförmige Scheibe, die diese haltenden Verbindungsstege und das kreisflächenförmige Plättchen bilden;
- Fig. 18: eine perspektivische Draufsicht auf die Anordnung gemäß Fig. 17;
- Fig. 19: eine Ansicht ähnlich Fig. 17, wobei hier kreisförmige Scheiben benachbart zu der verbleibenden, das zweite Pad-Element bildenden Ringscheibe, herausgestanzt sind, so dass verbleibende Löcher gebildet werden, die sicherstellen, dass die ersten und zweiten Pad-Elemente elektrisch getrennt sind;
- Fig. 20: eine Ansicht ähnlich der Fig. 19.

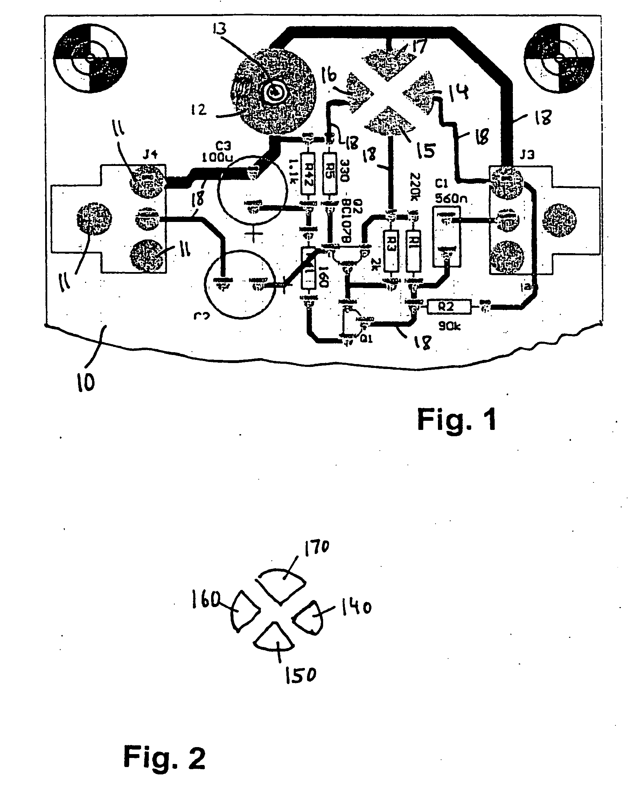

Fig. 1 ist eine schematische Draufsicht auf eine Oberfläche einer Leiterplatte 10, auf der Leiterplatten-Pads 11 gebildet sind, die beispielsweise eine kreisflächenförmige Gestalt besitzen. Zudem ist ein ringförmiges Leiterplatten-Pad 12 dargestellt, welches ein kreisflächenförmiges Leiterplatten-Pad 13 beabstandet umgibt. Ferner sind segmentförmige Leiterplatten-Pads 14, 15, 16 und 17 dargestellt. Leiterbahnen sind mit 18 bezeichnet.

Fig. 2 zeigt eine Draufsicht von vier lötfähigen, vorzugsweise plättchenförmigen und aus Metall bestehenden Anpresskontakten (wie noch erläutert wird, kann es sich auch allgemein um andere Bauteile z.B. Anschlusskontakte handeln), die auch (jedenfalls dann, wenn sie, was später erläutert wird, zusammen als eine Einheit hergestellt werden und gemeinsam, aber elektrisch isoliert voneinander, an die Leiterplatten-Pads angelötet werden) als Pad-Elemente 140, 150, 160, 170 bezeichnet werden können.

Diese separaten Pad-Elemente 140, 150, 160 und 170 werden mit den entsprechenden Leiterplatten-Pads 14, 15, 16 und 17 verlötet. Dabei treten die eingangs geschilderten Schwierigkeiten hinsichtlich der Positionierung der separaten Pad-Elemente 140, 150, 160 und 170 auf.

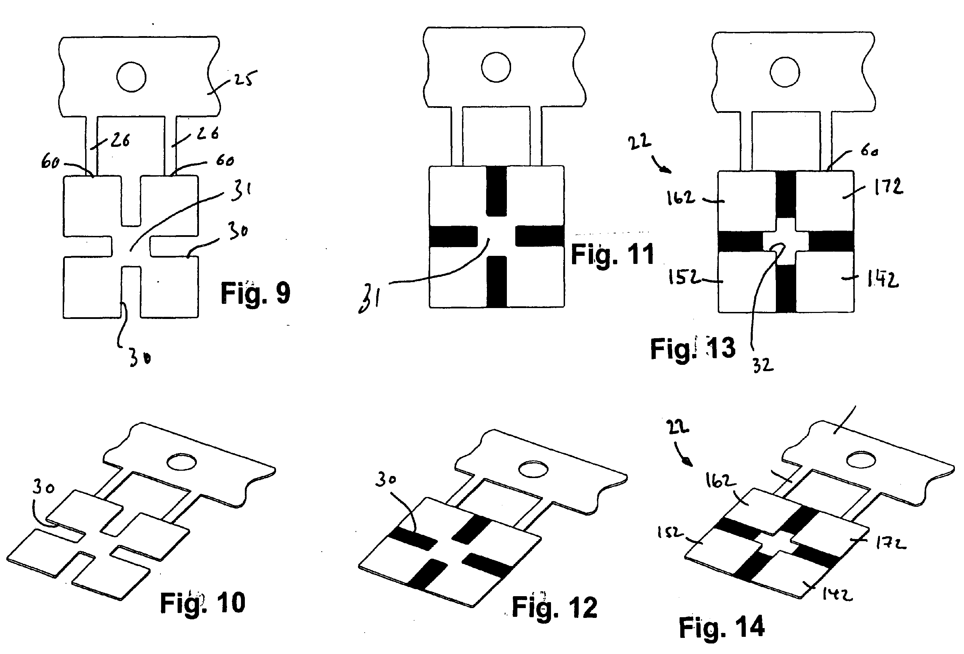

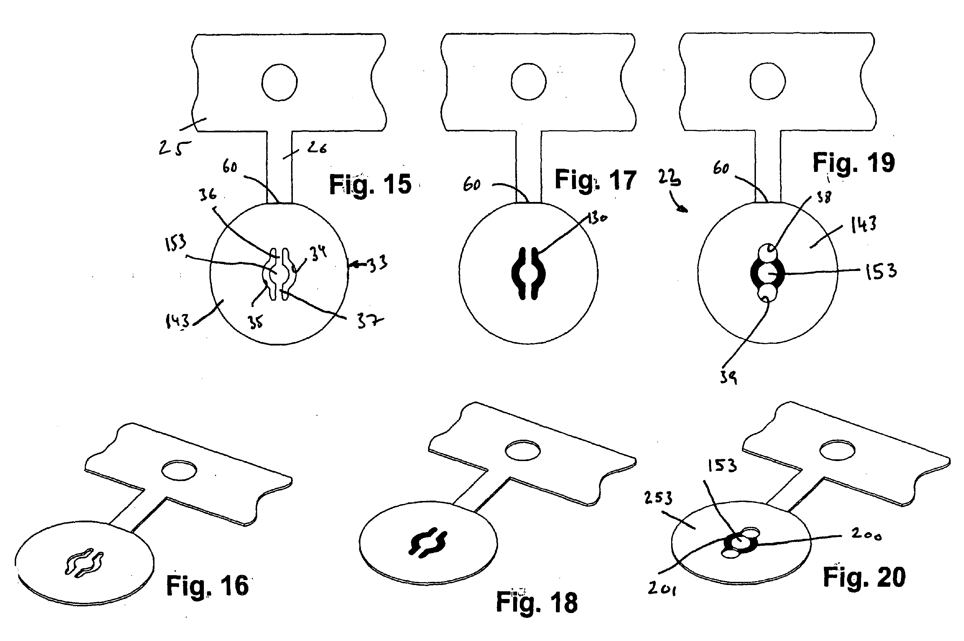

Erfindungsgemäß werden die auf einer Leiterplatte 10 anzulötenden Bauteile, insbesondere Pad-Elemente, die vorzugsweise als Anpresskontakte verwendet werden sollen, zu so genannten Anpresskontakt-Arrays oder Anpresskontaktanordnungen (allgemein: Anschlusskontaktanordnungen) 21, 22 und 23 zusammengefasst, wie dies für das erste Ausführungsbeispiel in den Figuren 7 und 8, für das zweite Ausführungsbeispiel in den Fig. 13 und 14 und für das dritte Ausführungsbeispiel in den Fig. 19 und 20 gezeigt ist. Erfindungsgemäß werden die Anpresskontaktanordnungen 21, 22, 23 dadurch gebildet, dass man die einzelnen als Anpresskontakte vorgesehenen Pad-Elemente mittels eines Formstoffs 130 verbindet und in diesem Zustand auf die Leiterplatte 10 auflötet. Es ist vorteilhaft, die Verbindung mittels eines Kunststoffspritzprozesses in den Stanzablauf mit einzubinden, so dass sich folgende Verfahrensschritte ergeben:
1. Werkzeug: Stanzen,
2. Werkzeug: Spritzen und
3. Werkzeug: Endstanzen.

Beginnend mit dem in den Fig. 3 bis 8 gezeigten ersten Ausführungsbeispiel seien die Herstellungsstufen der Anpresskontaktanordnung 21 (allgemein: Anschlussanordnung) erläutert. Fig. 3 zeigt einen Pilotstreifen 25, an dem mittels eines Stegs 26 vier Pad-Elemente 141, 151, 161, 171 der Anpresskontaktanordnung 21 befestigt sind. Fig. 3 und 4 veranschaulichen eine erste Herstellungsstufe der in Fig. 7 und 8 gezeigten lötfähigen Anpresskontaktanordnung 21. An dem Pilotstreifen 25 können mehrere derartige Anpresskontaktanordnungen 21 beabstandet angeordnet sein. Die einzelnen Pad-Elemente 141, 151, 161, 171 sind durch gestanzte Schlitze 28 getrennt und in dieser ersten Herstellungsstufe durch eine kreisflächenförmige Scheibe 27 verbunden.

In einer zweiten Herstellungsstufe gemäß Fig. 5 wird ein Formstoff 130 in die Schlitze 28 eingeführt. Der Formstoff 130 verbindet die Pad-Elemente 141, 151, 161, 171 miteinander vorzugsweise an den Kanten. Die Pad-Elemente 141, 151, 161, 171 bilden, nachdem in einer dritten Endstanzstufe das Herausstanzen der ein Loch 29 hinterlassenden Scheibe 27 (eines nicht erforderlichen Verbindungsteils) erfolgt, eine Einheit. Die in Fig. 7 und 8 gezeigte fertige Anpresskontaktanordnung 21 kann sodann in einfacher Weise mit den Leiterplattenkontakt-Pads 14, 15, 16, 17 ausgerichtet und angelötet werden. Nach dem Anlöten erfolgt in einem weiteren Schritt das Abtrennen des Stegs 26, vorzugsweise entlang einer Sollbruchstelle oder Sollbruchlinie.

Beim zweiten Ausführungsbeispiel gemäß den Fig. 9 bis 14 werden nicht segmentförmige Pad-Elemente gebildet, sondern quadratische Pad-Elemente 142, 152, 162 und 172. Diese sind gemäß den Fig. 9 und 10 durch Schlitze 30 getrennt, aber mittig mit einer kreuzflächenförmigen Scheibe 31 verbunden, die - wie man in Fig. 13 sieht - nach dem Herausstanzen ein kreuzflächenförmiges Loch 32 hinterlässt. Zwei Stege 26 verbinden jeweils die Pad-Elemente 162, 172 mit dem Pilotstreifen 25, Sollbruchstellen 60 sind, wie gezeigt, vorgesehen.

Auch bei diesem Ausführungsbeispiel wird ein Formstoff 130 in die Schlitze 30, vor dem Herausstanzen der Scheibe 31, eingespritzt und auf diese Weise werden die Pad-Elemente 142, 152, 162, 172 miteinander verbunden und bleiben auch dann verbunden, nachdem die kreuzförmige Scheibe 31 herausgestanzt ist. In dem Zustand gemäß den Fig. 13 und 14 wird die so gebildete Anpresskontaktanordnung 22 auf entsprechenden Leiterplatten-Pads platziert und angelötet.

Beim dritten Ausführungsbeispiel gemäß den Fig. 15 bis 20 weist, wie in Fig. 19 und 20 gezeigt, die Anpresskontaktanordnung (allgemein: Anschlusskontaktanordnung) 23 ein erstes Pad-Element 143 in der Form einer ringförmigen Kontaktscheibe und ein zweites Pad-Element 153 in der Form eines Kontaktplättchens auf.

In einer ersten Verfahrensstufe gemäß den Fig. 15 und 16 werden dazu in eine kreisförmige, vorzugsweise aus Metall bestehende Scheibe 33 spiegelbildlich zwei Schlitze 34 und 35 eingestanzt. Diese Schlitze 34, 35 bilden die Kontur für das zweite oder innere Pad-Element 153, d.h. einen ersten Anpresskontakt in der Form eines kreisförmigen Plättchens. Dieses zweite Pad-Element 153 (Anpresskontakt) ist gemäß Fig. 15 aber noch durch Verbindungsstege 36, 37 mit dem ersten, äußeren ringförmigen Pad-Element 143 (Anpresskontakt) verbunden.

Im zweiten Schritt gemäß den Fig. 17 und 18 werden die Schlitze 34, 35 mit Formstoff 130 ausgefüllt und anschließend werden in einem dritten Verfahrensschritt zwei kreisförmige Scheiben (nicht erforderliche Verbindungsteile) herausgestanzt, deren Durchmesser Löchern 38 und 39 gemäß den Fig. 19 und 20 entspricht. Somit sind die ersten und zweiten Pad-Elemente 143, 153 elektrisch getrennt aber mechanisch verbunden:

Durch den Formstoff 130 wird das innere Pad-Element 153 von dem äußeren Pad-Element 143 galvanisch getrennt, bleibt jedoch mechanisch mittels der Formstoffverbindungen 200, 201 mit Hilfe des Formstoffs 130 miteinander verbunden.

Vorzugsweise sind in den Verbindungen (d.h. den Stegen 26) zwischen den Pilotstreifen 25 und mindestens einem der Pad-Elemente 171; 162; 172; 253 Sollbruchstellen 60 vorgesehen.

Wie einleitend bemerkt, bezieht sich die Erfindung insbesondere auf eine Anordnung von Anpresskontakten, wobei die Anpresskontakte durch sogenannte Pad-Elemente gebildet werden, die wenn es sich um Anpresskontakte handelt, Anpresskontaktzonen aufweisen, in denen die Andruckkontaktierung erfolgt.

Allgemein können auch statt der Anpresskontakte, die durch Pad-Elemente realisiert sind, auch Anschlusskontakte in Anschlusskontaktanordnungen vorgesehen werden, um dann solange sie noch eine Einheit bilden, an Leiterplatten-Pads angelötet zu werden.

Wenn die Pad-Elemente als Anpresskontakte eingesetzt werden, so kann es zweckmäßig sein, in den Anpresskontaktzonen der Pad-Elemente eine galvanische Beschichtung vorzusehen.

Ferner sind vorzugsweise die eine Anschlusskontakt- oder Anpresskontaktanordnung bildenden Pad-Elemente in einer koplanaren Ebene miteinander verbunden. Vorzugsweise sind die eine Anschlusskontakt- oder Anpresskontaktanordnung bildenden Pad-Elemente aus einem Flächenelement, beispielsweise einem Metallblech gestanzt, wobei vorzugsweise Schlitze oder Ausnehmungen die Pad-Elemente voneinander abgrenzen. Nach dem Herausstanzen der die Ausnehmungen bildenden Blech- oder Flächenelementteile werden die dabei gebildeten Schlitze oder Ausnehmungen vollständig oder teilweise durch den Formstoff 130 ausgefüllt, der eine stabile mechanische Verbindung zwischen den unterschiedlichen Pad-Elementen herstellt, aber auch die Pad-Elemente voneinander elektrisch isoliert.

## Patentansprüche

1. Eine Anschlusskontaktanordnung, vorzugsweise Anpresskontaktanordnung, mit mindestens zwei Pad-Elementen (141, 151, 161, 171; 142, 152, 162, 172; 143, 153), **dadurch gekennzeichnet, dass** die Pad-Elementen voneinander durch Schlitze (28; 30; 34; 35) getrennt, und durch in diese Schlitze eingeleiteten Formstoff (130) mechanisch verbunden und elektrisch isoliert sind und somit eine Einheit bilden, die vorzugsweise insgesamt an Leiterplatten-Pads einer Leiterplatte (10) anlötbar ist.

2. Eine Anschlusskontaktanordnung nach Anspruch 1, **dadurch gekennzeichnet, dass** die Pad-Elemente Anpresskontaktelemente mit Anpresskontaktzonen sind.

3. Eine Anschlusskontaktanordnung gemäß Anspruch 1 oder 2, wobei die Pad-Elemente (141, 151, 161, 171) der Kontaktanordnung segmentförmig ausgebildet sind.

4. Eine Anschlusskontaktanordnung gemäß Anspruch 1 oder 2, wobei die Pad-Elemente (142, 152, 162, 172) der Kontaktanordnung (22) quadratisch ausgebildet sind.

5. Eine Anschlusskontaktanordnung nach einem der vorhergehenden Ansprüche **dadurch gekennzeichnet, dass** die Pad-Elemente an ihren Anpresskontaktzonen eine galvanische Beschichtung aufweisen.

6. Eine Anschlusskontaktanordnung nach einem der vorhergehenden Ansprüche **dadurch gekennzeichnet, dass** mindestens ein Pad-Element mit einem Pilotstreifen (25) verbunden ist.

7. Eine Anschlusskontaktanordnung gemäß Anspruch 6, **dadurch gekennzeichnet, dass** eine Verbindung (26) zwischen dem Pilotstreifen (25) und einem Pad-Element mittels einer Sollbruchstelle (60) verbunden ist.

8. Eine Anschlusskontaktanordnung nach einem der vorhergehenden Ansprüche **dadurch gekennzeichnet, dass** die Pad-Element alle in einer koplanaren Ebene miteinander mechanisch, elektrisch isoliert verbunden sind.

9. Eine Anschlusskontaktanordnung nach einem der vorhergehenden Ansprüche, wobei die Pad-Elemente aus Metallblech bestehen und vorzugsweise aus einem Metallblechstreifen ausgestanzt sind.

10. Eine Anschlusskontaktanordnung, wobei bei Verwendung der Pad-Elemente als Anpasskontakte auf dem Metallstreifen spezielle Anpressmetallflächen aufgebracht sind.

11. Verfahren zur Herstellung einer Anschlusskontaktanordnung und zur Anbringung von vorzugsweisen Anpresskontakten an einem oder mehreren Leiterplatten-Pads, wobei Folgendes vorgesehen ist:
a) Herausstanzen der Grundformen von zwei oder mehreren Pad-Elementen, b) Anfüllen der Zwischenräume zwischen den Pad-Elementen mit einem Formstoff (130), c) Herausstanzen von nicht erforderlichen Verbindungsteilen (27; 31; 37) und d) Ausrichten und Anlöten der Anschlusskontaktanordnung.

12. Verfahren gemäß Anspruch 11 **dadurch gekennzeichnet, dass** zwischen den Schritten c) und d) ein Pilotstreifen abgetrennt wird.

## Claims

1. A termination contact assembly, preferably a press contact assembly having at least two pad elements (141, 151, 161, 171; 142, 152, 162, 172; 143, 153), **characterized in that**
said pad elements are separated from one another by slots (28; 30; 34; 35) and are mechanically connected and electrically isolated from another by a forming material (130), which is introduced into said slots so as to form a unit which is, preferably in its totality, soldered to the circuit board pads of a circuit board (10).

2. A termination contact assembly as set forth in claim 1, **characterized in that** the pad elements are press-contact elements having press-contact zones.

3. A termination contact assembly according to claim 1 or 2, wherein the pad elements (141, 151, 161, 171) of the contact assembly are of segment shape design.

4. A termination contact assembly according to claim 1 or 2, wherein the pad elements (142, 152, 162, 172) of the contact assembly (22) are of square design.

5. A termination contact assembly according to one or more of the preceding claims, **characterized in that** the pad elements are provided at the press-contact zones with a galvanic coating.

6. A termination contact assembly according to one or more of the preceding claims, **characterized in that** at least one pad element is connected to a pilot strip (25).

7. A termination contact assembly according to claim 6, **characterized** that a connection (26) is provided with a predetermined braking point (60) between the pilot strip (25) and a pad element.

8. A termination contact assembly according to one or more of the preceding claims, **characterized in that** all pad elements are mechanically and electrically isolated connected to another in a coplanar plane.

9. A termination contact assembly according to one or more of the preceding claims, wherein the pad elements are made of sheet metal and a preferably stamped out of a metal sheet strip.

10. A termination contact assembly according to one or more of the preceding claims, wherein, for use of the pad elements as press-contacts special press-metal surfaces are provided on the metal strip.

11. A method for manufacturing an termination contact assembly and for mounting preferably press contacts at one or more circuit board pads, wherein the following steps are provided:
a) stamping out basic shapes of two or more pad elements,
b) filling the spaces between the pad elements with a form material (130),
c) stamping out connecting portions (27; 31; 37) which are not required, and
d) aligning and soldering the termination contact assembly.

12. The method according to claim 11, **characterized in that** between the steps c) and d) a pilot strip is separated.

## Revendications

1. Dispositif de connexion, de préférence dispositif à contact par pression comprenant au moins deux éléments de plot (141, 151, 161, 171 ; 142, 152, 162, 172 ; 143, 153), **caractérisé en ce que** :
les éléments de plot sont séparés les uns des autres par des fentes (28 ; 30 ; 34 ; 35) et sont mécaniquement connectés et électriquement isolés les uns des autres par un matériau de formage (130) qui est introduit dans les fentes de façon à former un tout qui est, de préférence en totalité, soudé aux plots de la carte de circuit d'une carte de circuit (10).

2. Dispositif de connexion selon la revendication 1, **caractérisé en ce que** les éléments de plot sont des éléments à contact par pression comprenant des zones de contact par pression.

3. Dispositif de connexion selon la revendication 1 ou 2, dans lequel les éléments de plot (141, 151, 161, 171) du dispositif de connexion sont en forme de segments.

4. Dispositif de connexion selon la revendication 1 ou 2, dans lequel les éléments de plot (142, 152, 162, 172) du dispositif de contact (22) sont de forme carrée.

5. Dispositif de connexion selon l'une quelconque des revendications précédentes, **caractérisé en ce que** les éléments de plot sont munis au niveau des zones de contact par pression d'un revêtement galvanique.

6. Dispositif de connexion selon l'une quelconque des revendications précédentes, **caractérisé en ce que** au moins un élément de plot est relié à une bande pilote (25).

7. Dispositif de connexion selon la revendication 6, **caractérisé en ce qu'**une connexion (26) est munie d'une zone de rupture prédéterminée (60) entre la bande pilote (25) et un élément de plot.

8. Dispositif de connexion selon l'une quelconque des revendications précédentes, **caractérisé en ce que** tous les éléments de plot sont isolés mécaniquement et électriquement et connectés les uns aux autres dans un même plan.

9. Dispositif de connexion selon l'une quelconque des revendications précédentes, dans lequel les éléments de plot sont formés à partir d'une feuille métallique qui est de préférence estampée en une bande métallique.

10. Dispositif de connexion selon l'une quelconque des revendications précédentes, dans lequel, pour l'utilisation des éléments de plot en tant que contacts par pression, des surfaces spécifiques de pression de métal sont prévues sur la bande métallique.

11. Procédé de fabrication d'un dispositif de connexion et de montage de contact de préférence par pression au niveau d'un ou plusieurs plots d'une carte de circuit, dans lequel on prévoit les étapes suivantes :
a) estamper les formes de base de deux ou plusieurs éléments de plot ;
b) remplir les espaces entre les éléments de plot d'un matériau de formage (130) ;
c) éliminer par estampage les parties de liaison (27 ; 31 ; 37) qui ne sont pas nécessaires ; et
d) aligner et souder le dispositif de connexion.

12. Procédé selon la revendication 11, **caractérisé en ce que**, entre les étapes c) et d), une bande pilote est séparée.
